Europäisches Patentamt

European Patent Office

Office européen des brevets

(11) Veröffentlichungsnummer: **0 348 794**
**A1**

## (12) EUROPÄISCHE PATENTANMELDUNG

(21) Anmeldenummer: **89111194.0**

(22) Anmeldetag: **20.06.89**

(51) Int. Cl.⁴: **C08J 3/20**

(30) Priorität: **29.06.88 DE 3821886**

(43) Veröffentlichungstag der Anmeldung:
**03.01.90 Patentblatt 90/01**

(84) Benannte Vertragsstaaten:
**BE DE FR GB IT NL**

(71) Anmelder: **BASF Aktiengesellschaft
Carl-Bosch-Strasse 38
D-6700 Ludwigshafen(DE)**

(72) Erfinder: **Hoenl, Hans, Dr.
Hauptstrasse 69a
D-6719 Obersuelzen(DE)**
Erfinder: **Kress, Gerhard, Dr.
Liebermannstrasse 7
D-6700 Ludwigshafen(DE)**

(54) **Gegen elektromagnetische Felder abschirmende Kunstharzmasse.**

(57) Formteile mit elektrisch leitfähigen bzw. die elektromagnetische Strahlung dämpfenden Füllstoffen, die nicht homogen verteilte Füllstoffe enthalten, sowie Verfahren zu ihrer Herstellung durch Verformung von Granulatmischungen.

EP 0 348 794 A1

## Gegen elektromagnetische Felder abschirmende Kunstharzmasse

Die rasche Entwicklung und große Verbreitung elektrischer Geräte hat in den letzten Jahren zu einer erheblichen Zunahme der Störstrahlung, d.h. der von den Geräten ausgestrahlten elektromagnetischen Strahlung geführt.

Die Störstrahlung kann die Nachrichtenübermittlung sowie andere Geräte und Einrichtungen, z.B. aus dem Bereich der Meß- und Regeltechnik und der Datenverarbeitung beeinflussen und auch der bisher wenig bekannte Einfluß von nichtionisierender Strahlung im Mikrowellenbereich auf den menschlichen Körper ist zu berücksichtigen.

In der Fachliteratur wird die mit der unkontrollierten Emission elektromagnetischer Wellen verbundene Problematik z.B. unter folgenden Stichworten behandelt: "Electromagnetic Interference" (EMI), "Radio Frequency Interference" (RFI), "Electromagnetic Compatibility" (EMC) und "Electromagnetic Propagation" (EMP).

Eine Möglichkeit, die Störstrahlung eines Gerätes daran zu hindern, das Gerät zu verlassen und sich unkontrolliert auszubreiten oder in ein solches Gerät von außen einzudringen, besteht in der Verwendung eines abschirmenden Gehäusematerials. Die weite Verbreitung von Gehäusen und Bauteilen aus Kunstharzen (Kunststoffen, Polymeren) läßt es als wünschenswert erscheinen, diesen die Eigenschaften metallischer, insbesondere eiserner Bauteile zu verleihen.

Bei der Verwendung von Kunststoffen gibt es grundsätzlich zwei Verfahren, um eine Schirmwirkung gegen elektromagnetische Wellen zu erreichen: Die Auftragung einer elektrisch leitfähigen Schicht auf das fertige Konstruktionsteil oder die Einbettung entsprechender leitfähiger Füllstoffe in die Polymermatrix. Im letzteren Fall werden viele Probleme beseitigt, die bei Verwendung leitfähiger Oberflächenschichten auftreten, zum Beispiel sind keine weiteren Verarbeitungsschritte nach der Herstellung eines Teils mehr nötig und es kann keine Beschädigung der leitfähigen Oberfläche während der Montage oder Anwendung vorkommen.

Es wurden schon Untersuchungen über die Wirkung von abschirmenden Füllstoffen angestellt, die beispielsweise in den folgenden Publikationen erörtert werden:

1. J. Joseph, Mod. Plast, Int. 1985, Seiten 56 bis 59 (1985)
2. H. Ebneth, H.-G. Fitzgy, Plastverarbeiter 33, Seiten 760 bis 764 (1982)
3. G. Smoluk, Mod. Plast. Int. 1982, Seiten 46 bis 49 (1982).

Die bisherigen Vorschläge zur Herstellung von Kunstharzmassen mit leitfähigen Füllstoffen befriedigen jedoch noch nicht, z.B. weil nur unbefriedigende Abschirmwirkung erreicht oder das mechanische Verhalten der Materialien verschlechtert wird gegenüber dem Verhalten entsprechender ungefüllter Bauteile.

Füllstoffe werden üblicherweise vor der Formgebung (z.B. durch Spritzguß) in den jeweiligen Kunststoff (etwa schlagfestes Polystyrol oder ABS) mittels Extruder unter Aufschmelzen eingearbeitet, ein homogenes Granulat hergestellt und dieses dann erst der Formgebung unterworfen.

Überraschenderweise zeigte es sich jedoch, daß man die beste Abschirmung dann erreicht, wenn nicht compoundierte füllstoffhaltige Kunststoffe eingesetzt werden, sondern Mischungen aus füllstoff-freiem Kunststoff mit einer geringen Mengen an Kunststoff, der den erfindungsgemäßen Füllstoff in hoher Konzentration enthält.

Aufgabe der Erfindung ist es demnach, ein Verfahren anzugeben, mit dem Formteile erhalten werden können, die eine - bezogen auf die jeweilige Wandstärke eines Bauteils - möglichst hohe elektromagnetische Dämpfung erzielen.

Erfindungsgemäß können Formteile mit verbesserter Dämpfung mit elektrisch leitfähigen bzw. die elektromagnetische Strahlung dämpfenden Füllstoffen dadurch erhalten werden, daß man ein Granulat eines - insbesondere thermoplastischen - Polymeren A und ein Granulat eines den Füllstoff enthaltenden weiteren Polymeren B in geeigneten Mengen mischt und unmittelbar zum gewünschten Formteil verarbeitet. Die erfindungsgemäßen Formteile erhalten durch die unvollständige Vermischung von Grundmaterial und Füllstoff einen nicht vollständig homogenen Aufbau; hierauf kommt es offenbar an.

Als Polymere (A) sind z.B. thermoplastisch verarbeitbare Polymere geeignet: Polystyrol, Styrol-Butadien-Copolymere, Styrol-AcrylnitrilCopolymere, ABS-Polymere, Polycarbonat, Polyphenylenether und deren Mischungen.

Diese Polymerisate sind auch als Polymere B geeignet; man verwendet sie mit einer entsprechend höheren Füllstoffmenge angereichert, so daß durch Mischen mit dem füllstofffreien oder weniger stark gefüllten Polymeren A das beabsichtigte Mischungsverhältnis bzw. der beabsichtigte Füllstoffgehalt erreicht wird. Man verwendet bei der Verarbeitung Geräte, die eine relativ geringe Vermischung bewirken. Es können grundsätzlich sowohl rein thermoplastisch verarbeitbare als auch bei der Verarbeitung vernetzende Polymere B verwendet werden; günstig werden Polymere B verwendet, die mit dem Polymeren A schlecht mischbar sind.

Als Füllstoffe eignen sich zum Beispiel Aluminiumpartikel (sog. Transmet-Schuppen (Omya), metallisierte Glaskugeln (Silver coated glass spheres; Potters Industries inc.) oder Stahlfasern.

Stahlfasern sind handelsüblich; erhältlich sind z.B. BEKI-SHIELD-Stahlfasern der Firma BEKAERT im Handel. Da der Durchmesser dieser Fasern sehr gering ist (ca. 20 bis 30 μm), besitzen solche Stahlfasern gegenüber anderen bekannten metallischen Zusätzen den Vorteil, daß die mechanische Qualität der damit hergestellten gefüllten Kunststoffe kaum verschlechtert wird.

Der Füllstoffgehalt (Metallgehalt) der Polymermischung beträgt z.B. 1 bis 20, insbesondere 5 bis 10 Gew.%. Die Polymermischung kann außerdem noch andere Füllstoffe, z.B. Pigmente oder Glasfasern enthalten, die in beliebiger Weise zugesetzt sein können. Der Füllstoffgehalt des Polymeren B beträgt z B. 20 bis 80, insbesondere 50 bis 80 Gew.%.

Im folgenden wird anhand der Beispiele 1 bis 4 und der Vergleichsversuche I bis IV gezeigt, daß durch Spritzguß unmittelbar verarbeitete Granulatmischungen zu besseren Abschirmwerten führen als herkömmliche Compounds. Für die Herstellung der erfindungsgemäßen Formteile und der Vergleichsgegenstände wurden die nachstehend beschriebenen Rohstoffe verwendet.

Die Wirksamkeit einer Abschirmung (Schirmdämpfung, engl. "shielding effectiveness" SE) wird durch Messung des Unterschieds der Feldstärke oder der Strahlungsintensität im definierten Abstand vor und nach dem Anbringen der Abschirmung bestimmt. Bei Frequenzen oberhalb etwa 30 MHz (UKW und Mikrowellenbereich) werden meist direkt Intensitäten, unterhalb 30 MHz dagegen Spannungen gemessen.

Die Schirmdämpfungswerte werden in logarithmischen Dezibel(dB)-Einheiten angegeben und sind wie folgt definiert:

$SE = 20 \log E_b/E_a$ (V/m)

$SE = 20 \log H_b/H_a$ (A/m)

$SE = 10 \log P_b/P_a$ (V/m²)

Hierbei bedeuten a und b die entsprechenden Werte für E, H bzw. P für ein gemessenes Feld vor bzw. nach dem Schirm.

10 dB Schirmdämpfung bedeuten eine Reduzierung der Intensität um den Faktor 10, 20 dB Reduzierung um den Faktor 100 usw. In den meisten Arbeiten wird die Schirmwirkung eines Werkstoffs im Bereich bis 1.000 MHz angegeben.

Komponente A

Ein schlagfestes Polystyrol mit einem Polybutadiengehalt von 13,0 Gew.%; mittlere Teilchengröße der Weichphase: 3 μm (Mittelwert; 50 Vol.-% der als Weichphase vorliegenden Kautschukpartikel liegen oberhalb dieses Wertes), enthaltend 0,12 Gew.% eines sterisch gehinderten Phenols als Antioxydans und 3,1 Gew.% Weißöl als Schmiermittel; Vz der Hartmatrix: 70 ml/g, liegt als Granulat vor.

Komponente B

Granulat BEKI-SHIELD GR 75/C10/4. Enthält außer 75 Gew.% Stahlfasern noch 25 Gew.% thermoplastisches Epoxyharz.

Herstellung der Mischungen

Die Granulatmischungen wurden mittels eines Rhönradmischers hergestellt; die zum Vergleich hergestellten Schmelzemischungen mittels eines Zweiwellenschneckenkneters (ZSKS) der Firma Werner & Pfleiderer (Massetemperatur: 210 °C ).

Herstellung der Formteile

Art der Spritzgußmaschine: DEMAG Typ D 175 NC II (Massetemperatur: 280 °C). Es wurden rechteckige Behälter spritzgegossen: 1 = 23 cm, B = 12 cm, h = 7 cm, d = 2 mm.

Messung der Abschirmwirkung SE

Die Abschirmwirkung SE wurde nach der Koaxialmethode nach ASTM ES 7-83 gemessen. Die Werte der mit den entsprechenden Mischungen hergestellten Behälter sind in Tabelle 1 wiedergegeben.

Tabelle 1

| Versuchsnummer | Komponente A (Gew.%) | Komponente B (Gew.%) | Art der Mischung | SE (dB) |
|---|---|---|---|---|
| 1 | 92 | 8 | Granulatmischung | 28 |
| 2 | 90 | 10 | Granulatmischung | 30 |
| 3 | 88 | 12 | Granulatmischung | 33 |
| 4 | 86 | 14 | Granulatmischung | 35 |
| I | 92 | 8 | Schmelzemischung | 19 |
| II | 90 | 10 | Schmelzemischung | 22 |
| III | 88 | 12 | Schmelzemischung | 24 |
| IV | 86 | 14 | Schmelzemischung | 27 |

## Ansprüche

1. Formteil mit elektrisch leitfähigen bzw. die elektromagnetische Strahlung dämpfenden Füllstoffen, dadurch gekennzeichnet, daß es in der Formmasse nicht homogen verteilte Füllstoffe enthält.

2. Verfahren zur Herstellung von Formteilen mit elektrisch leitfähigen bzw. die elektromagnetische Strahlung dämpfenden Füllstoffen, dadurch gekennzeichnet, daß man ein Granulat eines Polymeren A und ein Granulat eines den Füllstoff enthaltenden weiteren Polymeren B in entsprechender Menge mischt und unmittelbar zum gewünschten Formteil verarbeitet.

3. Formteil mit elektrisch leitfähigen bzw. die elektromagnetische Strahlung dämpfenden Füllstoffen, das nicht homogen verteilte Füllstoffe enthält, wie es erhalten wird, wenn man ein Granulat eines Polymeren A und ein Granulat eines den Füllstoff enthaltenden weiteren Polymeren B in einer solchen Menge mischt, daß ein gewünschter Füllstoffanteil in der Mischung erhalten wird und die Mischung unmittelbar zum gewünschten Formteil verarbeitet.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | US-A-4 467 060 (BIING-LINLEE) --- | | C 08 J 3/20 |
| A | EP-A-0 002 108 (IMPERIAL CHEMICALS LTD) --- | | |
| X,P | GB-A-2 207 435 (ARMSTRONG WORLD IND.) * Claims 1,2 * ----- | 1-3 | |

RECHERCHIERTE SACHGEBIETE (Int. Cl.5)

C 08 J
C 08 K
C 08 L

Der vorliegende Recherchenbericht wurde für alle Patentansprüche erstellt

| Recherchenort | Abschlußdatum der Recherche | Prüfer |
|---|---|---|
| DEN HAAG | 09-10-1989 | WILSON A.J.D. |

EPO FORM 1503 03.82 (P0403)